Europäisches Patentamt

European Patent Office

Office européen des brevets

(11) Publication number: **0 429 993 B1**

# EUROPEAN PATENT SPECIFICATION

(45) Date of publication of patent specification: **02.08.95**

(51) Int. Cl.⁶: **C23C 14/06**, C23C 14/22, C23C 14/48, G11B 5/255

(21) Application number: **90121978.2**

(22) Date of filing: **16.11.90**

(54) **Method of forming thin film containing boron nitride, magnetic head and method of preparing said magnetic head.**

(30) Priority: **17.11.89 JP 300376/89**
**17.11.89 JP 300377/89**
**20.12.89 JP 332108/89**

(43) Date of publication of application:
**05.06.91 Bulletin 91/23**

(45) Publication of the grant of the patent:
**02.08.95 Bulletin 95/31**

(84) Designated Contracting States:
**DE FR GB**

(56) References cited:
**JP-A-60 063 372**
**US-A- 4 656 052**

**THIN SOLID FILMS, vol. 142, no. 1, 15th August 1986, pages 83-99, New York, NY, US; B. ROTHER et al.: "Preparation and characterization of ion-plated boron nitride"**

**PATENT ABSTRACTS OF JAPAN, vol. 11, no. 208 (P-593)[2655], 7th July 1987**

**PATENT ABSTRACT OF JAPAN, vol. 13, no. 69 (C-569)[3417], 16th February 1989**

(73) Proprietor: **NISSIN ELECTRIC COMPANY, LIMITED**
**No.47, Umezu Takase-cho**
**Ukyo-ku**
**Kyoto-shi**
**Kyoto (JP)**

(72) Inventor: **Nishiyama, Satoshi, c/o Fuji Photo Film Co., Ltd.**
**No. 210 Nakanuma**
**Minami Ashigara-shi,**
**Kanagawa (JP)**
Inventor: **Ogata, Kiyoshi, c/o Fuji Photo Film Co., Ltd.**
**No. 210 Nakanuma**
**Minami Ashigara-shi,**
**Kanagawa (JP)**
Inventor: **Kirimura, Hiroya, c/o Fuji Photo Film Co., Ltd.**
**No. 210 Nakanuma**
**Minami Ashigara-shi,**
**Kanagawa (JP)**

(74) Representative: **Patentanwälte Grünecker, Kinkeldey, Stockmair & Partner Maximilianstrasse 58 D-80538 München (DE)**

## Description

BACKGROUND OF THE INVENTION

Field of the Invention

The present invention relates to methods of forming a boron nitride (BN) thin film and particularly to methods of forming said BN thin film on a substrate such as the sliding surface of a magnetic head, and to a magnetic head comprising a sliding surface coated with a BN thin film.

In one preferred embodiment, this invention relates to a method of preparing a thin film consisting essentially of the c-BN structure capable of remarkably improving the wear resistance of machining tools, metal dies, and various mechanism elements or magnetic heads by coating their surface therewith.

In another preferred embodiment, the invention relates to a magnetic head and a method of preparing magnetic heads for recording and reproducing signals to and from a magnetic recording medium.

Discussion of the Related Art

Boron nitrides are classified into such three types as hexagonal (h-BN), cubic (c-BN), and close-packed hexagonal of wurtzite structure (w-BN) by the crystal structure. Among them, cubic boron nitride c-BN has excellent properties including high thermal conductivity, high insulation, and high hardness. With these attractive properties c-BN is considered to have great potential for applications in coating thin films in various fields such as semiconductors and tools.

The methods of forming a BN thin film include chemical vapor deposition (CVD) methods and physical vapor deposition (PVD) methods.

The CVD methods, on the one hand, comprise the steps of: introducing a mixed gas consisting of a boron containing gas and a nitrogen containing gas into a reaction chamber after having arranged therein a substrate on which a BN thin film will be formed; and causing the mixed gas to interact with the substrate that is heated. The PVD methods, on the other hand, include a sputtering method in which a target is sputtered by ion species and the sputtering particles are deposited on the substrate thereby to form a thin film thereon, and an ion plating method in which incoming particles are ionized and the ionized particles are accelerated up to several to several tens of keV in an electric field thereby to be deposited on the substrate.

However, the above-described CVD methods require that the substrate be maintained at high temperatures (over ca. 500 °C), thereby making it not only difficult to form a BN thin film composed essentially of the c-BN structure at low temperatures but also inevitably cause a soft h-BN to grow. Also, the PVD methods such as the sputtering method and the ion plating method are not successful in selectively developing the c-BN structure.

Various attempts have recently been made to improve wear resistance and other properties in fields demanding wear protection. Among them are the methods or coating the surface of a substrate with a thin film of BN, and particularly, the c-BN structure described above.

This is not only because both the c-BN is harder than titanium nitride and titanium carbide which have been the major wear resistant thin films and but also because BN has many excellent properties such as no affinity for iron materials and chemical stability in contradistinction with very hard diamond, and thermal stability.

Amongst the conventional methods of forming the hard c-BN thin film including the PVD methods and CVD methods described above, it is desirable, from a practical viewpoint, to adopt a method that allows a highly adhesive thin film to be prepared at low temperatures at which the substrate is free from thermal damage or deformation. To this end, as disclosed in Japanese Patent Unexamined Publication No. 63372/1985 (60-63372), a method of forming a thin film containing very hard BN is proposed, in which a substance containing boron is evaporated on the surface of a substrate simultaneously or alternately with injecting accelerated ions.

This method provides advantages not only of dispensing with the use of a heated substrate but also of making the surface of the substrate harder by newly forming a mixed layer composed of the substrate forming atoms and the vapor deposited atoms that have entered into the interior of the substrate through collision with and repelling against the injected ions.

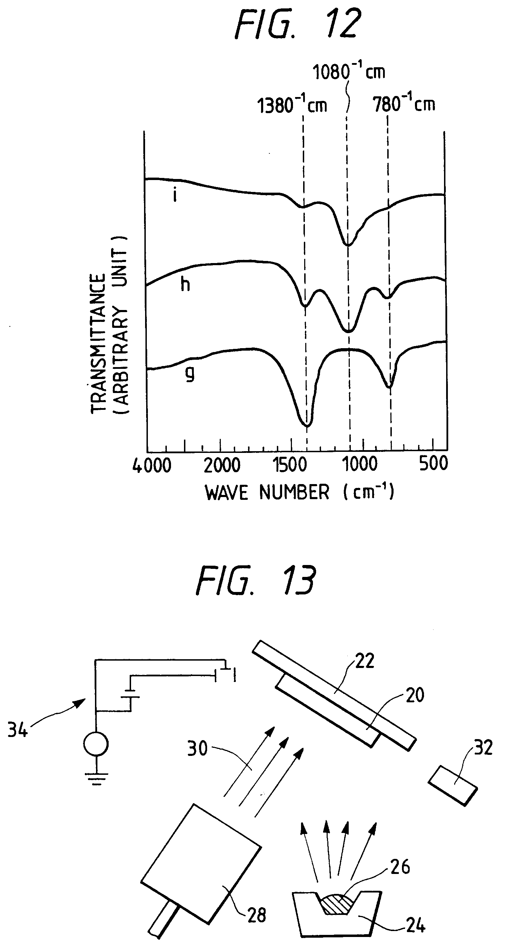

An exemplary method of forming the conventional thin film containing very hard BN will be described with reference to FIG. 13.

Within a vacuum unit (not shown) a substrate 20 is secured to a holder 22. Below the substrate 20 is an evaporation source 24 such as an electron beam, a laser beam, or a high frequency inductor for heating the substrate to high temperatures. The evaporation source 24 contains therein an evaporation substance 26 consisting essentially of monatomic boron and boron oxides or boron nitrides. Opposite to the substrate 20 is an ion source 28 of Kaufmann type or bucket type using a KAPUSU field for plasma confinement.

This ion source 28 serves to ionize a gas in which nitrogen molecules, nitrogen atoms, or a nitrogen gas are mixed with an inert gas thereby to prepare ions 30 containing nitrogen, and to inject the prepared ions 30 on the substrate 20. The vacuum unit also accommodates a thickness gauge 32 and a current measuring instrument 34.

The thickness gauge 32 is, e.g., of an oscillating type using a crystal oscillator for measuring not only the thickness of the film composed of the evaporation substance 26 to be vapor deposited on the surface of the substrate 20 but also the amount of boron particles. The current measuring instrument 34 is, e.g., an ion beam current measuring instrument of cup type having a secondary electron suppressing electrode such as a Faraday cup for measuring the amount of nitrogen ions, i.e., the number of atoms of the nitrogen ions, in the injected ions 30.

In the above construction, the evaporation substance 26 is vapor deposited on the surface of the substrate 20 made of silicon from the evaporation source 24, and at the same time the ions 30 containing the nitrogen ions are injected from the ion source 28 at an acceleration energy of 5 keV thereby to form 3000Å thick thin films containing BN on the surface of the substrate 20 by adjusting the particle ratios of boron ions to nitrogen ions to be injected on the substrate 20 (hereinafter referred to simply as "B/N ratio") to predetermined values.

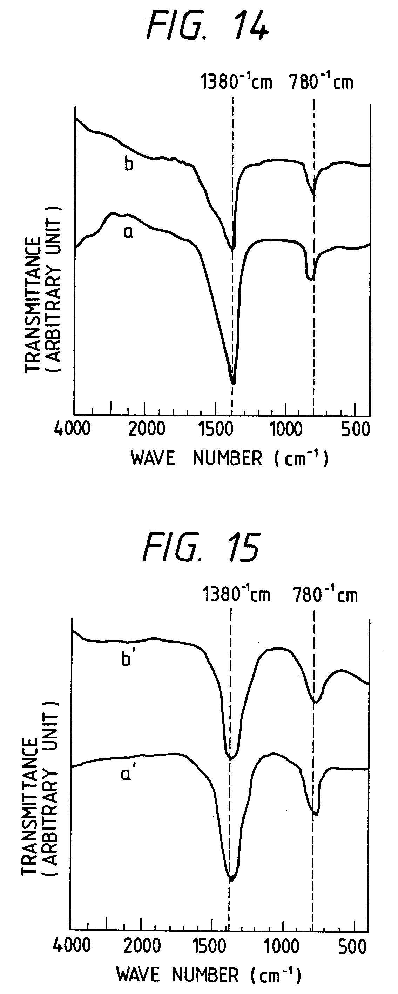

The thus prepared thin films containing BN were subjected to infrared spectroscopy, the result of which is shown in FIG. 14, where a and b are the infrared absorption spectra of the samples whose B/N ratios of the ions reaching the substrate 20 were 1 and 3, respectively. Each sample exhibited a strong absorption peak at 1380 cm$^{-1}$ and 780 cm$^{-1}$. The c-BN infrared absorption spectrum exhibited an absorption peak at 1080 cm$^{-1}$ while the infrared absorption spectrum of a low pressure phase BN that is analogous to a hexagonal graphite h-BN structure exhibited absorption peaks at 1380 cm$^{-1}$ and 780 cm$^{-1}$, and from this it is understood that the above two samples are h-BN containing thin films.

Now, as another conventional example, 3000Å thick thin films containing BN were formed on the surface of the substrate 20 by adjusting the acceleration energy of the ions 30 to 20 keV and the B/N ratios to predetermined values using the same unit and materials as above.

The infrared absorption spectra of the thus prepared thin films containing BN are shown in FIG. 15, where a′ and b′ are the infrared absorption spectra of the respective thin films whose B/N ratios of the ions reaching the substrate 20 were 1 and 2, respectively. Under the above conditions, absorption peaks were observed only at 1380 cm-1 and 780 cm-1 which correspond to the h/BN absorption peak, thereby confirming that the films containing BN of these two samples are of h-BN structure.

Thus, the above method allows only a thin film containing h-BN to be formed on the substrate 20 with the c-BN structure barely mixed in the h-BN thin film, and this has presented the problem of not being able to make the most of the wear resistance and other excellent properties of the c-BN structure.

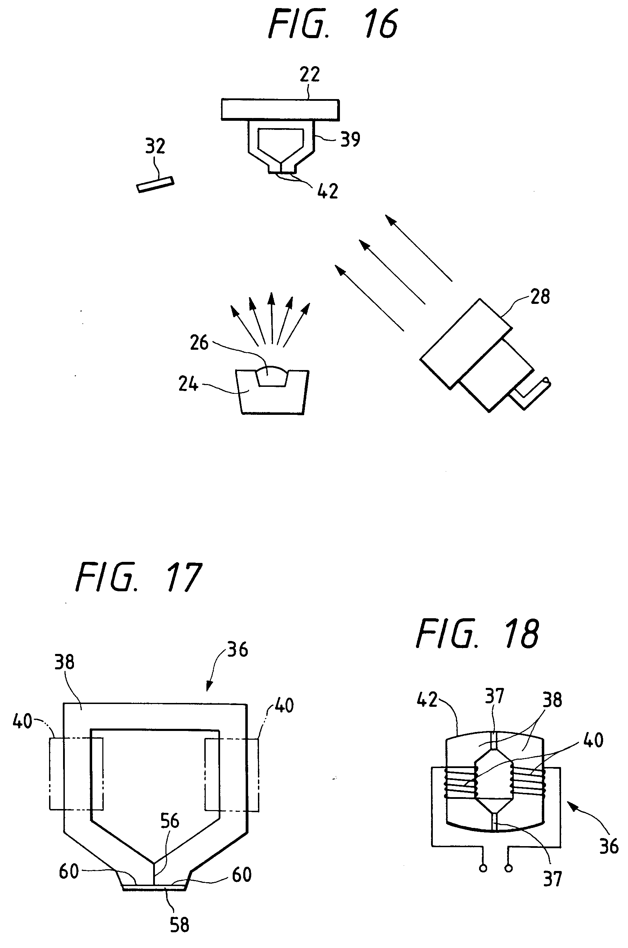

FIG. 18 is a schematic diagram showing the basic structure of a magnetic head. As shown in FIG. 18, the magnetic head 36 is-formed by first arranging gaps 37 between two opposing pieces of a head core 38 made of a magnetic substance which is machined into a predetermined profile and around which a coil 40 is wound and then being secured to a sealed case (not shown) by, e.g., an adhesive. A sliding surface 42 along which the head core 38 and a magnetic recording medium such as a magnetic tape slide (not shown) is ground in advance.

Since the magnetic head 36 thus constructed usually has its sliding surface 42 worn due to its being slid with the magnetic recording medium, there is a tendency that the life of the magnetic head depends on the amount of such wear.

A recently adopted technique for increasing the performance of video tape recorders and the like using a magnetic head is to accelerate the travelling speed of the magnetic tape. However, this is disadvantageous because it increases the wear of the magnetic head, thereby curtailing its life.

Thus, to prevent the wear of the magnetic head, attempts have been made to harden a material of the head core. As disclosed in Japanese Patent Examined Publication No. 12652/1980, the attempt involves the process of injecting ions of a metal hardening atom on a contact surface, or sliding surface, between the ground head core and the magnetic tape serving as a magnetic recording medium by an ion injection method to harden the surface of the head core.

However, in such an attempt, the metal hardening atoms adversely affect the magnetic properties of the head core by not only generating distinct lattice imperfections to the head core but also distorting the head core lattice. Moreover, to ensure a sufficient wear resistance for the head core, a layer of sufficient thickness must be provided to allow the head core to be hardened; however, this simultaneously increases the thickness of the layer that defines the magnetic properties, thereby inevitably impairing its performance as a magnetic head.

Another method of preventing magnetic head wear is to coat its sliding surface with a hard wear resistant film.

Such a method includes physical vapor deposition (PVD) methods such as a vacuum vapor deposition method, a sputtering method, and an ion plating method or chemical vapor deposition (CVD) methods for forming thin films such as titanium nitride (TiN) and titanium carbide (TiC). These methods further include a cluster ion beam vapor deposition method in which borides are vapor deposited on the sliding surface of the magnetic head using metallic vapor as proposed in Japanese Patent Unexamined Publication No. 126383/1976.

However, the above methods including the vacuum vapor deposition method, the sputtering method, the ion plating method, and the cluster ion beam vapor deposition method are, on the one hand, not able to provide sufficient adhesion between the head core and the wear resistant film formed on its surface, and present the problem of separating the wear resistant film from the head core surface by its sliding with the magnetic tape. The CVD method, on the other hand, requires that the substrate (in this case, the head core of the magnetic head) be heated to a temperature, e.g., around 1000°C, and this heat may deteriorate head core properties.

Further, Japanese Patent Unexamined publication No. 275308/1987 proposes a method of forming a boron nitride (BN) film on the sliding surface of the head core of a magnetic head as a wear resistant film.

The BN films are, e.g., of a cubic zinc blend structure c-BN and of a hexagonal graphite structure h-BN. Amongst them, the c-BN structure are very hard and have excellent mechanical wear resistance. Their hardness is far greater than that of TiN, TiC, and silicon carbide which have been the major conventional wear resistant materials. The BN film not only is chemically and thermally stable but also has no affinity for iron materials, thus making itself an optimal wear resistant material for magnetic heads.

In addition, the h-BN structure is highly lubricative and slidable with a low friction coefficient. Thus, a BN film having a mixture of c-BN and h-BN structures in appropriate amounts is an excellent coating material with satisfactory wear resistance and slidability.

In the case where a magnetic head is coated with diamond that is harder than the BN film as a wear resistant film, the diamond works better in mechanical wear resistance than the c-BN structure, but its affinity to iron materials and its thermal instability lead to eventual thermal wear and deterioration of the diamond thin film due to its sliding with the magnetic tape.

In light of the above circumstances, it is the BN film that is most suitable as a wear resistant film for magnetic heads.

However, with a magnetron sputtering method and the vacuum vapor deposition method a BN film which can provide sufficient adhesion between the surface of the magnetic head and the film itself formed thereon may not be prepared. In particular, the c-BN structure can be formed only under the special conditions such as high temperatures and high pressures, and this makes it difficult to form a thin film of these structures and coat the surface of a substrate therewith. In addition, there is no precedent of coating a magnetic head with a very adhesive and hard BN film at low temperatures at which the respective parts forming the magnetic head are not adversely affected.

A method of forming a thin film having a c-BN structure and having the features of the first parts of claims 1 and 2 is known from US-PS 46 56 052.

The object of this invention is to provide a method of forming a thin film consisting essentially of the c-BN structure that can improve wear resistance with a c-BN thin film having a satisfactory adhesion to the surface of a substrate and a high hardness.

A further object of the invention is to provide a magnetic head and a method of preparing a magnetic head coated with a BN film that is highly wear resistant and slidable at room temperature.

This object is solved by a method of forming a thin film of c-BN having the features of claims 1 and 2.

The method for forming boron nitride thin film comprises forming a boron nitride thin film by injecting on a surface of a substrate nitrogen ions simultaneously or alternatively with vapor depositing thereon boron. In addition to nitrogen ions, at least one kind of inert gas is injected on said surface simultaneously with vapor depositing boron thereon in the above manner, whereby an injection energy of said nitrogen ions and said inert gas ions is limited to a range of from 500 eV to 2 keV. In the embodiment wherein nitrogen ions and at least one inert gas is injected on said surface simultaneously with vapor depositing boron thereon, a mixed gas consisting of an inert gas and a nitrogen gas at a ratio (inert gas/nitrogen gas) of between 10 and 80% is supplied to an ion source, or the ratio of injection amount of the inert gas ions to the nitrogen ions is between 0.1 and 0.8.

The invention involves preparing a thin film consisting of boron and nitrogen by injecting nitrogen ions on a substrate simultaneously or alternately with vapor depositing boron under vacuum, the method being conducted under the following conditions where X is the acceleration energy (eV) of injection of said ions, and Y is the particle ratio (B/N composition ratio) of boron atoms (B) and nitrogen atoms (N) to be contained in said thin film:

when $X \leq 1000$,

$$Y \geq 6.25 \times 10^{-4} \times (X-200) + 2$$
$$Y \leq 1.25 \times 10^{-3} \times (X-200) + 4;$$

when $1000 < X \leq 2000$,

$$Y \geq 5.0 \times 10^{-4} \times (X-1000) + 2.5$$
$$Y \leq 5.0 \times 10^{-3} \times (X-1000) + 5;$$

when $2000 < X \leq 5000$,

$$Y > 3.0$$
$$Y \leq 2/3 \times 10^{-3} \times (X-2000) + 10;$$

when $5000 < X \leq 10000$,

$$Y > 4.0 \times 10^{-4} \times (X-5000) + 3$$
$$Y \leq 1.2 \times 10^{-3} \times (X-5000) + 12; \text{ and}$$

when $10000 < x \leq 40000$,

$$Y \geq 1/3 \times 10^{-4} \times (X-10000) + 5$$
$$Y \leq 2/3 \times 10^{-3} \times (X-10000) + 18.$$

Another preferred embodiment of the invention is a magnetic head comprising a sliding surface coated with a BN thin film consisting essentially of the c-BN structure. The thin film coating is formed by the above-described methods of claims 1 or 2.

## BRIEF DESCRIPTION OF THE DRAWINGS

The accompanying drawings, which are incorporated in and constitute a part of this specification illustrate embodiments of the invention and, together with the description, serve to explain the objects, advantages and principles of the invention. In the drawing

FIG. 1 is a schematic diagram showing an exemplary construction of a thin film forming device to be used for an embodiment of the invention;

FIG. 2 is a schematic diagram showing an exemplary construction of a thin film forming device to be used for another embodiment of the invention;

FIG. 3 is a diagram showing the XD result of the respective samples of Examples 1 and 2, and Comparative example 1;

FIGS. 4 and 5 are diagrams respectively showing the XPS results of the sample of Example 1;

FIG. 6 is a diagram showing the XD result not only of the respective samples of Examples 1 and 2, and Comparative example 1 but also of the samples whose B/N composition ratio is 3 and 5 by increasing the boron deposition rate of the above respective samples;

FIG. 7 is a diagram showing the result of Knoop hardness measurement made not only on the respective samples of Examples 1 and 2, and Comparative example 1 but also on the samples whose B/N composition ratio is 3 and 5 by increasing the boron vapor deposition rate of the above respective samples;

FIGS. 8 and 9 are graphs showing the relationship between the B/N composition ratio and the acceleration energy in the method of forming a thin film containing very hard BN of this inventions;

FIG. 10 is a chart showing the infrared absorption spectrum of the thin film containing very hard BN prepared by Example 3;

6

FIG. 11 is a chart showing the infrared absorption spectra of the thin films containing very hard BN prepared by Example 4;

FIG. 12 is a chart showing the infrared absorption spectra of the thin films containing very hard BN prepared by Example 5;

FIG. 13 is a schematic diagram showing a device for forming a thin film containing very hard BN;

FIG. 14 is a chart showing the infrared absorption spectra of thin films containing very hard BN prepared by an exemplary conventional method;

FIG. 15 is a chart showing the infrared absorption spectra of thin films containing very hard BN prepared by another exemplary conventional method;

FIG. 16 is a schematic diagram showing a thin film forming device to be used for an embodiment of the invention;

FIG. 17 is a schematic diagram showing the structure of a magnetic head to which the invention is applied;

FIG. 18 is a schematic diagram showing the basic structure of a conventional magnetic head.

## DESCRIPTION OF THE PREFERRED EMBODIMENTS

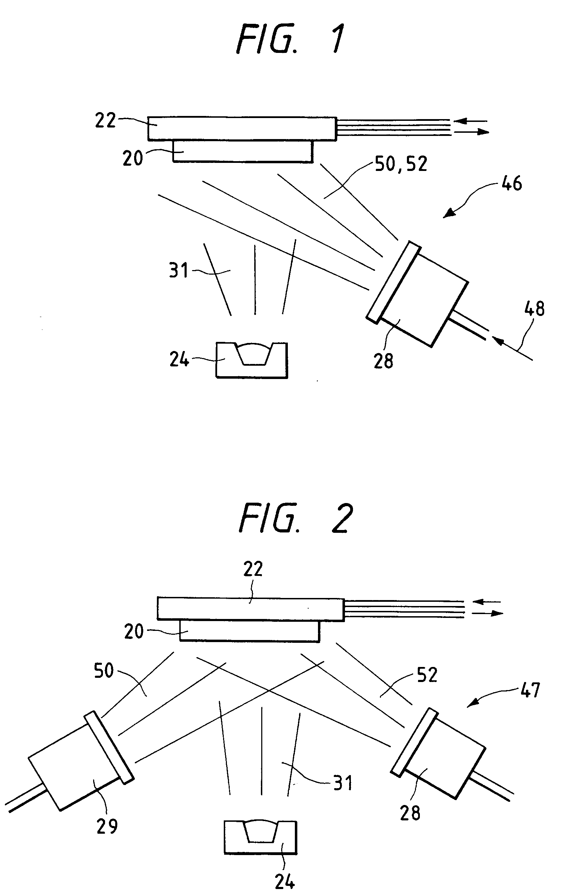

As shown in FIG. 1, substrate 20 on which a BN thin film will be formed is secured to substrate holder 22. Evaporation source 24 and an ion source 28 are disposed at positions opposed to a surface of the substrate 20.

The substrate 20, the substrate holder 22, the evaporation source 24, and the ion source 28 are accommodated within a vacuum container (not shown) and the vacuum container is evacuated to a pressure suitable for thin film deposition.

The substrate 20 is water-cooled to be kept at a low temperature.

Using the thin film forming device 46 thus constructed, boron ions 31 are vapor deposited on the surface of the substrate 20 from boron 25 contained in the evaporation source 24 and at the same time a mixed gas 48 consisting of an inert gas and a nitrogen gas is charged into the ion source 28 thereby to cause the ion source 28 to inject inert gas ions 50 and nitrogen ions 52 on the substrate to form a BN thin film thereon.

In this case, it is preferable to confine the injection energies of the inert gas ions 50 and the nitrogen ions 52 to the range of from 500 eV to 2 keV. Injection energies outside this range may result in damage such as internal defects to the formed BN thin film.

It is also preferable to limit the ratio of the mixed gas 48 (the inert gas/the nitrogen gas) to a range of from 10 to 80%, these gases being supplied to the ion source 28 for the injection of the inert gas ions 50 and the nitrogen ions 52. This is because the amount of the inert gas and the nitrogen gas to be introduced to the ion source 28 directly contributes to the injection dose of the inert gas ions 50 and the nitrogen ions 52. In addition, the ratio of the mixed gas 48 below 10% makes insufficient the excitation energy from the inert gas ions 50 for the B-N bonding in the formation of the BN thin film on the substrate 20, while the ratio of the mixed gas 48 over 80% provides an insufficient dose of injection of the nitrogen ions 52, thereby discouraging the B-N interaction in the formation of the BN thin film on the substrate 20. Thus, the above gas mixing ratio range is proposed to allow BN thin films consisting essentially of the c-BN structure to be formed efficiently.

In addition, it is preferable to limit the particle ratio (B/N) of the boron ions 31 to the nitrogen ions 52, both reaching the substrate 20, to a range of from 0.7 to 1.5. Ratios outside this range, e.g., above 1.5, increases boron deposition on the substrate 20, thereby making it impossible to obtain a BN thin film with satisfactory properties.

The inert gas includes He, Ne, Ar, Kr, and Xe, at least one kind of which is to be supplied to the ion source.

A thin film formation process is conducted under this condition. The nitrogen ions 52 interact with the boron ions 31 to form a BN film of such crystal structure as c-BN, h-BN, or wBN. The inert gas ions 50 injected simultaneously with the nitrogen ions 52 make the nitrogen ions 52 and the boron ions 31 in excited states for their interaction, hence promoting the formation of the c-BN that can only be developed at high temperatures and high pressures.

Thus, the c-BN having such satisfactory film properties as high thermal conductivity, high insulation, and high hardness can selectively be prepared on the substrate 20 that is maintained at a low temperature by the water-cooled substrate holder 22.

As shown in Fig. 2, substrate 20 on which to form a BN thin film is secured to substrate holder 22. Evaporation source 24 for evaporating boron 25, an ion source 29 for injecting inert gas ions 50, and an ion source 27 for injecting nitrogen ions 52 are disposed at positions opposed to a surface of the substrate 20.

Substrate 20, substrate holder 22, evaporation source 24, ion source 29, and ion source 27 are accommodated within a vacuum container (not shown) and the vacuum container is evacuated to a pressure suitable for thin film deposition. Substrate 20 is water-cooled to be kept at a low temperature.

Using the thin film forming device 47 thus constructed, the boron ions 31 are vapor deposited on the surface of substrate 20 from evaporation source 24 and at the same time the inert gas ions 50 and the nitrogen ions 52 are injected on the substrate from ion source 29 and ion source 27, respectively, thereby to form a BN thin film thereon.

The separate injection of the inert gas ions 50 and the nitrogen ions 52 by the two separate ion sources 29 and 27 allows their injection energies to be adjusted individually, and this in turn contributes to individually adjusting the injection energies of both the nitrogen ions 52 that cause the boron ions 31 to interact therewith and the inert gas ions 50 that excite this interaction. In this case, it is preferable to limit the injection energies of inert gas ions 50 from ion source 29 and nitrogen ions 52 from ion source 27 to a range of from 500 eV to 2 keV. Injection energies outside this range may cause damage such as internal defects to the formed BN thin film.

It is also preferable to limit the ratio of inert gas ions 50 to nitrogen gas ions 52, both reaching substrate 20, to a range of from 0.1 to 0.8, because injections with energies below the lower limit value, 0.1, makes short of the excitation energy given by inert gas ions 50 for the BN bonding, and as a result inert gas ions 50 do not encourage the interaction between the boron ions 31 and the nitrogen ions 52 as much as they should, while injections with energies above the upper limit value, 0.8, do not expedite the interaction between the boron ions 31 and the nitrogen ions 52 due to insufficient dose of the latter, thereby producing a film having an excessive boron content.

The inert gas to be charged into the ion source 29 for injecting inert gas ions 50 includes He, Ne, Ar, Kr, and Xe, at least one kind of which is supplied to ion source 29.

In addition, it is preferable to limit the particle ratio (B/N) of the boron 31 to the nitrogen ions 52, both reaching substrate 20, to a range of from 0.7 to 1.5. Ratios outside this range, e.g., above 1.5, increases boron deposition on substrate 20, thereby making it impossible to obtain a BN thin film with excellent properties.

Thus, the c-BN having such satisfactory properties as high thermal conductivity, high insulation, and high hardness can selectively be prepared on substrate 20 that is maintained at a low temperature by water-cooled substrate holder 22.

While an electron beam is used as the evaporation source 24 for vapor depositing boron ions 31 in the above description, the evaporation source may be other means such as resistance heating, not shown.

According to the method of forming a BN thin film of the invention, the BN thin film is formed by vapor depositing boron vapor on the substrate simultaneously or alternatively injecting nitrogen ions and inert gas ions thereon to cause the inert gas ions to keep the boron and the nitrogen ions in excited states for their interaction. As a result, the c-BN whose development has been limited only to a high temperature and pressure environment can be promoted at low temperatures.

Example 1

After evacuating the vacuum container to $2.66 \times 10^{-4}$ Pa ($2 \times 10^{-6}$ Torr) or less using the thin film forming device shown in FIG. 1, boron (whose purity is 99.7% or more) was vapor deposited on the surface of a substrate made of a single crystal silicon wafer (CZ-N and cut at [100] plane) that was maintained at room temperature, and at the same time nitrogen ions and argon ions were injected while charging a mixed gas into an ion source thereby to form a 5000ÅA thick BN thin film under the following conditions:

| | |
|---|---|
| Mixing ratio (argon gas/nitrogen gas): | 30% |
| Injection energy of nitrogen ions and argon ions: | 2 kV |
| Current density of nitrogen ions and argon ions: | 0.15 A/cm$^2$ |
| Boron deposition rate: | 1Å/sec |

The inert gas and the nitrogen gas was supplied to the ion source by a mass flow controller.

Example 2

A BN thin film was formed on a subsirate in a manner similar to that in Example 1 except that the mixing ratio (argon gas/nitrogen gas) of a mixed gas to be charged into the ion source was 50%.

Comparative example 1

A BN thin film was formed on a substrate in a manner similar to that in Example 1 except that the mixing ratio (argon gas/nitrogen gas) of a mixed gas to be supplied to the ion source was 0%; i.e., only nitrogen gas was supplied.

The respective samples of BN thin films prepared by Examples 1 and 2, and Comparative example 1 was subjected to X-ray diffractometry (XD), X-ray photoelectron spectroscopy (XPS), and Knoop hardness measurement.

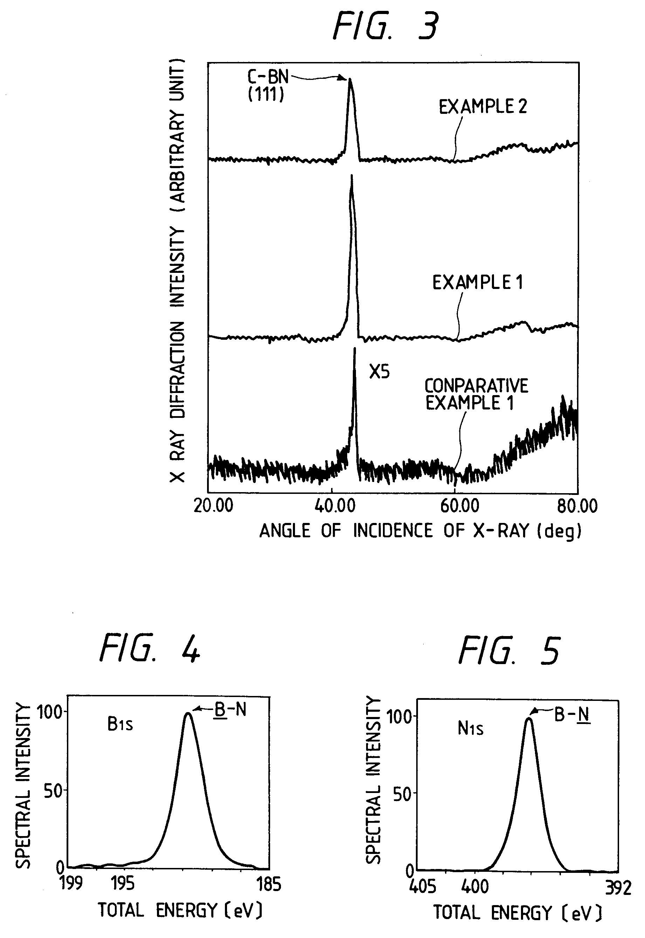

FIG. 3 is a diagram showing the XD result of the respective samples of Examples 1 and 2, and Comparative example 1. As shown in FIG. 3, each sample unanimously exhibited a diffraction peak at a diffraction angle of $2\theta$ = 43.3°, which corresponds to the (111) c-BN diffraction peak. However, an examination of the diffraction intensity, which is an indicator of crystallographic properties, shows that the sample of Example 1 has a diffraction intensity approximately 5 times that of the sample of Comparative example 1 while the sample of Example 2 has a diffraction intensity approximately 3 times that of the sample of Comparative example 1. It is clear from this fact that the samples of Examples 1 and 2 have a better growth of c-BN crystal phases compared to the sample of Comparative example 1.

A Cu K$\alpha$ X-ray line ($\lambda$ = 1.5406Å) was used.

FIGS. 4 and 5 are diagrams showing the XPS result of the sample of Example 1.

As shown in FIGS. 4 and 5, an examination of the chemical bonding of the sample based on its spectral distribution revealed the presence of only the B-N chemical bonding from the $B_{IS}$ and $N_{IS}$ bonding energies.

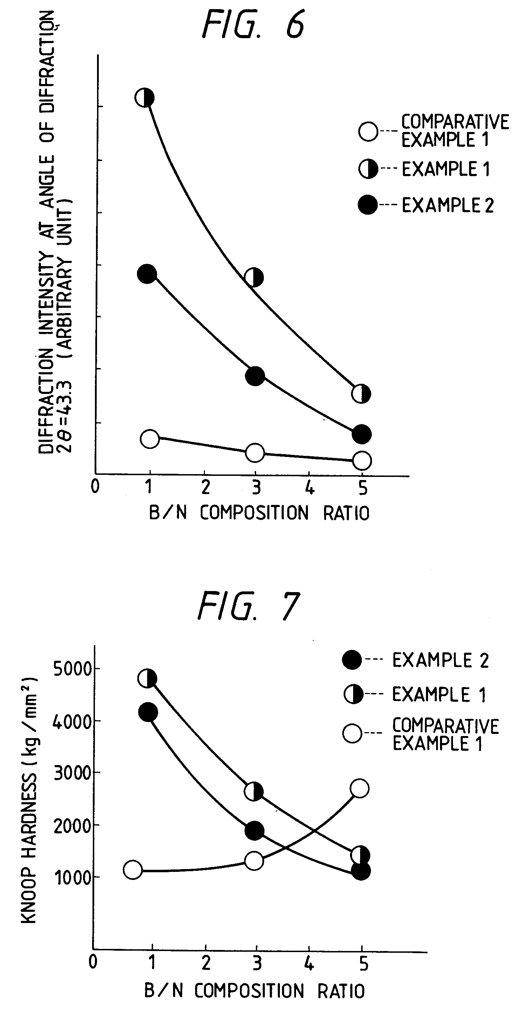

FIG. 6 is a diagram showing the XD result of the respective samples of Examples 1 and 2, and Comparative example 1 adding the measuring points of which B/N composition ratios were enhansed to 3 and 5 by increasing the boron deposition rates of the above respective samples.

The abscissa of the diagram indicates the B/N composition ratio, while the ordinate the diffraction peak intensity at a diffraction angle of $2\theta$ = 43.3° that corresponds to the c-BN diffraction peak observed in the XD made on each sample.

As shown in FIG. 6, the diffraction peak intensities at the angle of diffraction 43.3° that corresponds to the c-BN diffraction peak shows a tendency toward decreasing with increasing B/N ratio. However, it is understood that samples of Examples 1 and 2 have high diffraction peaks at the diffraction peak of the hard c-BN structure than that of Comparative example 1 irrespective of their B/N ratio. In particular, it is clear that the sample of Example 1, in which the B/N ratio is 1 and the mixing ratio (argon gas/nitrogen gas) is 30%, exhibited the maximum intensity at the c-BN diffraction peak.

FIG. 7 is a diagram showing the result of the Knoop hardness measurement made on the respective samples of Examples 1 and 2, and Comparative example 1 adding the measuring points of which B/N composition ratios were enhanced to 3 and 5 by increasing the boron deposition rates of the above respective samples.

As shown in FIG. 7, it was verified that the Knoop hardness tends to decrease with increasing B/N composition ratio on the samples in which the mixing ratio of the argon gas to the nitrogen gas was 30% and 50%.

The sample of Example 1 whose B/N composition ratio was 1 had a Knoop hardness as high as 4800 kg/mm$^2$, revealing a significant development of the hard c-BN structure.

It is understood from the above XD and Knoop hardness data measurements the respective samples of Examples 1 and 2 exhibited a markedly high hardness compared to that of comparative example 1 and that the c-BN structure was selectively developed. In addition, from an examination of the chemical bonding of the Example 1 sample by XPS it is indicated that the film of the sample was highly dense and adhesive due to its having only the B-N chemical bonding with no influence of the inert gas ions.

According to the method of forming a BN thin film, it is arranged so that boron vapor deposition on the surface of the substrate coincides with the injection of nitrogen ions and inert gas ions thereby to cause the inert gas ions to make the nitrogen ions and boron in excited states for their interactions. Therefore, the BN thin films consisting essentially of the c-BN structure, which have been developed only under high temperature/pressure environment by the related art method, can be formed selectively at low temperatures. As a result, it is possible to form a BN thin film consisting essentially of the c-BN having excellent film properties also on a substrate that is not thermally resistant. In addition, the injection energies of the nitrogen ions and the inert gas ions to the substrate being relatively low contributes to forming a high-quality BN thin film free from damage such as internal defects. Moreover, since it is only the nitrogen gas and the inert gas that are supplied to the ion source for ion injection and thus no active impurity gases (e.g., $H_2$) are incorporated, a crystal structure consisting only of the B-N bonding can be generated, hence allowing the formation of a BN thin film that is excellent in crystallographic properties, adhesion, and hardness.

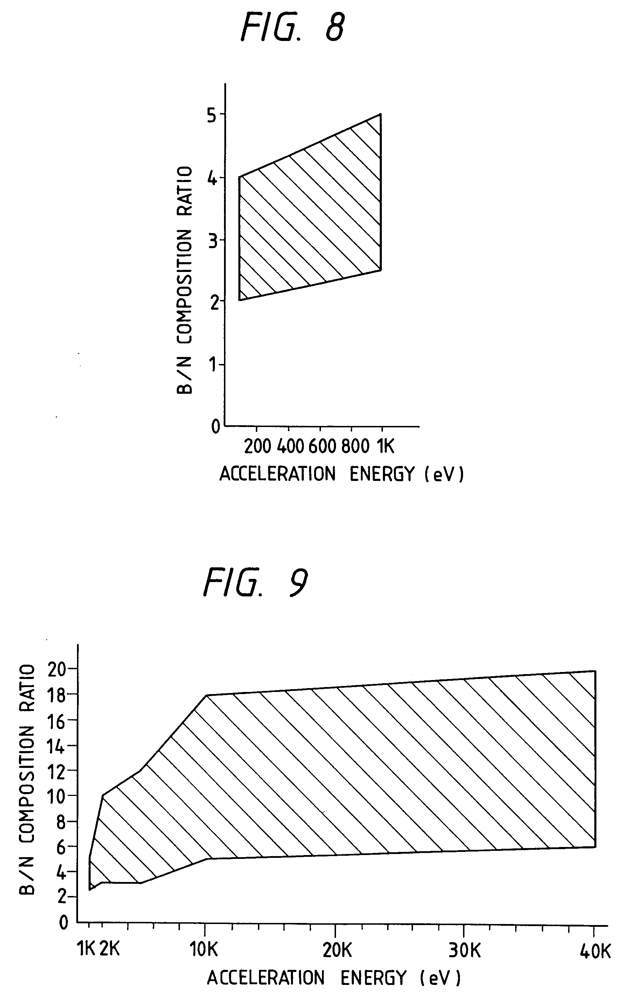

The conditions of the above noted fifth aspect of the invention were obtained through structural analyses and hardness measurements on various samples of the thin films containing BN that were prepared by varying the ion acceleration energies and the B/N ratios. In addition, sputtering of boron particles contained in the thin films due to ion injection was also taken into consideration. These conditions are presented by the shaded regions in FIGS. 8 and 9.

The thin films containing BN with a small boron content prepared under the lower limit values of the B/N composition ratio shown in FIGS. 8 and 9, i.e., the conditions below the bottom lines of the shaded regions, are low in hardness due to a large h-BN content. The BN containing thin films with a large boron content prepared under the upper limit values of the B/N composition ratio shown in FIGS. 8 and 9, i.e., the condition above the top lines of the shaded regions, have their hardness and corrosion resistance such as oxidation resistance decreased by the boron that has not yet been interacted. In addition, injection energies smaller than 100 eV decrease the adhesiveness of the thin films, while those greater than 40 keV cause surface defects or thermal damage on the surface of the substrate.

In forming thin films for parts such as magnetic heads which require not only hardness-assisted wear protection but also slidability, a thin film containing BN composed essentially of the c-BN structure and having a relatively large content of the lubricative h-BN structure may be prepared by adjusting both the B/N ratio and the acceleration energy so as to be around the lower limit values of the shaded regions shown in FIGS. 8 and 9 in which the relationship between the acceleration energy and the B/N composition ratio is shown.

The method of forming a thin film containing very hard BN allows a thin film containing BN of the c-BN structure to be formed by adjusting the acceleration energy of ions and the number of particles of both boron and nitrogen atoms in the formed thin film while controlling the B/N ratio.

Example 3

Using the same device as that shown in FIG. 13 in the conventional example, a silicon substrate 20 was placed on the holder 22 within the vacuum unit, which was evacuated to $2.66 \times 10^{-4}$ Pa ($2 \times 10^{-6}$ Torr) or more. Below the substrate 20 was an evaporation substance 26 composed of 99% pure boron supplied within an evaporation source 24 that was to be heated by an electron beam.

Under this arrangement, a value of the B/N ratio of the ions reaching the substrate 20 was measured by the thickness gauge 32 and the current measuring instrument 34 while cooling the substrate 20 with a cooling unit (not shown), and the evaporation substance 26 was evaporated from the evaporation source 24 such that it was vapor deposited on substrate 20 with the B/N ratio being 7, and at the same time a 5N pure nitrogen gas was supplied to the ion source 28 and the nitrogen ions were injected on the substrate 20 at an acceleration energy of 5 keV thereby to form a 3000Å thick thin film containing BN. The angle of incidence of ions 30 to substrate 20 (the angle that the line perpendicular to the surface of substrate 20 makes with the injection direction of ions 30) was adjusted to 0°.

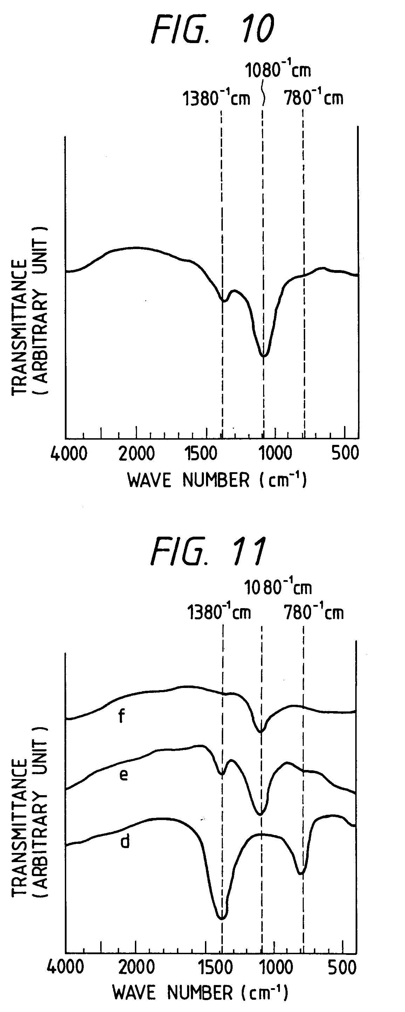

The thus prepared BN thin film was subjected to infrared spectroscopy for their composition and structure analyses, the result of which is shown in FIG. 10. As is apparent from the chart, the absorption peak at 1080 cm$^{-1}$ is the strongest in the infrared absorption spectrum, verifying that the BN of the formed thin film is essentially of the c-BN structure. Moreover, the B/N composition ratio measured by X-ray photoelectron spectroscopy (XPS) was 5.5. The hardness of this BN containing thin film measured by a 5gf load Vickers micro-hardness gauge was 5000 Hv.

Example 4

BN containing thin films were formed on substrate 20 to prepare samples d, e, and f under the same conditions as in Example 3 except that the B/N ratio was varied to 1, 3, and 5 with the acceleration energy of ions 30 maintained constant at 500 eV.

The thus prepared samples d, e, f were subjected to 5gf load Vickers micro-hardness measurement and infrared spectroscopy. Their B/N composition ratios and Vickers hardness values are shown in Table 1 below and their infrared absorption spectra are shown in FIG. 11.

Table 1

| Sample | B/N ratio | B/N composition ratio | Hardness (Hv) |
|--------|-----------|------------------------|----------------|
| d | 1 | 1 | 1000 |
| e | 3 | 3 | 5500 |
| f | 5 | 5 | 4000 |

From these data it is understood that sample e, exhibiting a strong absorption peak at 1080 cm-1, is a very hard film with e large c-BN content among samples d, e, f in which their B/N composition ratios were varied by varying their B/N ratios while injecting the ions 30 at an acceleration energy of 500 eV.

Example 5

Thin films containing BN were formed on substrate 20 to prepare samples g, h, and i under the same conditions as in Example 3 except that the B/N ratio was varied to 3, 10, and 15 with the acceleration energy of the ions 30 maintained constant at 10 keV.

The thus prepared samples g, h, i were subjected to 5gf load micro Vickers hardness measurement and infrared spectroscopy. Their B/N composition ratios and Vickers hardness values are shown in Table 2 below and their infrared absorption spectra are shown in FIG. 12.

Table 2

| Sample | B/N ratio | B/N composition ratio | Hardness (Hv) |
|--------|-----------|------------------------|----------------|
| g | 3 | 2 | 1200 |
| h | 10 | 9 | 3800 |
| i | 15 | 14 | 6500 |

From these data it is understood that sample i, exhibiting a strongest absorption peak at 1080 cm$^{-1}$ and weak absorption peaks at 1380 cm$^{-1}$ and 780 cm$^{-1}$, is a very hard film having a large c-BN content among the samples g, h, i in which the B/N composition ratios were varies by varying their B/N ratios while injecting the ions 30 at an acceleration energy of 10 keV.

While the angle of incidence at which the ions 30 are injected was adjusted to 0° in each example, the angle may take various values, and the material of the substrate 20 may also be other than silicon including metals, ceramics, and high molecular materials.

The method of forming a thin film containing very hard BN of this invention allows a thin film containing BN of the c-BN structure which is highly adhesive to the substrate and very hard by controlling the B/N ratio of ions injected to the surface of the substrate while adjusting the acceleration energy of the ions.

As shown in FIG. 16, a head core material 39 of a magnetic head on which to form a BN film is secured to a holder 22. Evaporation source 24 and ion source 28 are disposed at positions opposite to a sliding surface 42 of the head core material 39. Thickness gauge monitor 32 serves to measure the thickness of the BN film formed on the sliding surface 42 of the head core material 38. Head core material 38, evaporation source 24, ion source 28, and the like are accommodated within a vacuum container (not shown) and kept at pressure suitable for film deposition.

Such a thin film forming device A vapor deposits boron that is an evaporation substance 26 from evaporation source 24 on sliding surface 42 of head core material 39 simultaneously or alternately with injecting nitrogen ions on sliding surface 42 of head core material 39 from ion source 28.

Evaporation source 24 is of an electron beam type, in which the boron is vapor deposited on the sliding surface 42 of the head core material 39 while heating and evaporating the boron by an electron beam. Other techniques such as a resistance induction heating may also be applied.

The ion source 28 is, e.g., of a bucket type using a multiple field for plasma confinement, in which an ion beam, being uniform and of large area, obtained by ionizing a gas supplied to the ion source 28 is injected toward the sliding surface 42 of the head core material 39.

The ion source 28 may be of other systems which are not particularly limited.

11

The angle of incidence of ions from the ion source 28 (the angle that the line perpendicular to the sliding surface 42 makes with the incident ion) may be selected from the range of from 0 to 80° as appropriate.

The ion species to be injected from the ion source 28 is not particularly limited but may be any material as long as it can form the c-BN and the w-BN structure through its interaction with boron which will be vapor deposited on the surface of the head core. For example, a mixture of nitrogen ions and inert gas ions may also be used.

The inert gas ions interact with boron not only to sufficiently elevate the boron atoms to excited states thereby to encourage the generation of the c-BN and the w-BN structure but also to enhance the crystallographic properties of the BN film.

It is preferable to adjust the acceleration energy of the nitrogen ions and inert gas ions, to the range from 200 eV or more to 40 keV or less. This is because acceleration energies below 200 eV are inadequate to obtain a satisfactory adhesion due to insufficient thickness of a mixing layer of boron or BN with the ion species, while acceleration energies above 40 keV cause the ion species to penetrate into the head core material 39 more than required, thereby adversely affecting the magnetic properties of the magnetic head. Thus, it is more preferable to opt the acceleration energy from the range of from 500 eV or more to 20 keV or less.

It is also preferable to limit the atomic ratio of boron to nitrogen (B/N ratio) contained in the evaporating atoms or the ion species reaching the head core material 39 to the range of from 0.5 to 30. Ratios outside this range decrease the amount of growth of the hard c-BN and w-BN structures contained in the formed BN film, thereby making the wear resistance of the BN film short of what it should normally be.

When the nitrogen ions are injected on the surface of the head core material 39 with the boron vapor deposited thereon, the inert gas ions may be mixed with the nitrogen ions as appropriate.

The above method of forming the BN film allows the c-BN and w-BN structures that are hard to be developed in the BN film at ambient temperature, and in addition to the property of hardness, the amounts of growth of the c-BN, the w-BN, and the h-BN structure in the BN film can be controlled by adjusting the ion injection energy, the B/N ratio, or the ion to BN ratio. That is, the wear resistance and lubricativeness of the BN film can optionally be adjusted depending on the application.

For example, in the thin film forming device shown in FIG. 16, the BN film formed by vapor depositing the boron on the surface of the head core material 39 simultaneously or alternately with injecting the nitrogen ions with an injection energy of 2 keV or less and at a B/N ratio of 0.5 or more is a film consisting essentially of the h-BN structure that is highly lubricative. On the other hand, the BN film thus formed except for a nitrogen ion injection energy of 2 keV or less and a B/N ratio of between 2 and 8 is a film consisting essentially of the c-BN structure that is highly wear resistant.

FIG. 17 is a schematic diagram showing the structure of a magnetic head to which the invention is applied. As shown in FIG. 17, a magnetic head 35 comprises a coil 41 wound around a head core 39 made of a magnetic substance having a high magnetic permeability and a gap 56 between two opposing pieces of the head core 39. A BN film 58 that is highly wear resistant and slidable is formed on a surface 60 along which the head core 39 and a magnetic recording medium such as a magnetic tape slide.

The head core 39 may be made of a material such as MnZn ferrite, permalloy, and Sendust. The shape and dimensions of the head core 39 may not particularly be limited, either. That is, the magnetic head shown in FIG. 17 is for purposes of presenting a basic structural concept and therefore may be of any design as long as its surface slid by the magnetic recording medium is coated with a BN film.

If, in preparing the magnetic head 35, the process of fixing the magnetic head 35 to a sealed case (not shown) and a magnetic head supporting body (not shown) by, e.g., an adhesive or a resin precedes the formation of the BN film on the sliding surface 42 of the head core 39, a film with excellent properties and adhesion may be obtained even at such low temperatures as cooling the head core 39 as necessary.

According to the method of preparing a magnetic head of the invention, the BN film is formed either by vapor depositing the boron on the sliding surface of the magnetic head simultaneously or alternately with injecting the ions including the nitrogen ions or by vapor depositing the boron simultaneously or alternately with injecting the mixture of nitrogen ions and the inert gas ions. Therefore, not only the c-BN and w-BN structures that are hard can be positively developed in the BN film by the injection of such ion species at ambient temperature, but also the amount of growth of the c-BN, w-BN, and h-BN structures in the BN film can be controlled by adjusting the ion injection energy, the B/N ratio, or the ion/BN ratio. Moreover, injection of accelerated ions aggravates the collision and repelling of the evaporation substance with and from the ions thereby to cause the evaporation substance to penetrate deep into the coated surface to form a mixing layer consisting of the BN and the coated surface, thereby allowing the BN film that is highly adhesive to be obtained.

Example 6

Using the thin film forming device shown in FIG. 16, a 2000Å thick BN film was formed by: evacuating a vacuum container (not shown) to $1.33 \times 10^{-4}$ Pa ($1 \times 10^{-5}$ Torr) or less; and heating a substrate made of a Mn-Zn ferrite single crystal plate (5 mm long x 5 mm wide x 1 mm thick) with a 99% pure boron evaporation material from an electron beam evaporation source thereby to cause the boron to be vapor deposited on the substrate simultaneously with injecting nitrogen ions whose acceleration energy was 2 keV while supplying a 5N pure nitrogen gas to the ion source.

The B/N ratio of boron to nitrogen ions, both reaching the surface of the substrate, was 1. The ion beam from the ion source was injected perpendicularly to the surface of the substrate.

Example 7

A BN film was formed in a manner similar to that in Example 6 except that the B/N ratio was 4.

Example 8

A BN film was formed in a manner similar to that in Example 6 except that the acceleration energy of the nitrogen ions was 500 eV.

Example 9

A BN film was formed in a manner similar to that in Example 6 except that the B/N ratio was 10 and the acceleration energy of the nitrogen ions was 10 keV.

Example 10

A BN film was formed on a substrate similar to that of Example 6 in a manner similar to that in Example 6, and at the same time, by additionally supplying a 5N pure Ar gas to the ion source and injecting the Ar ions at an acceleration energy of 2 keV. The Ar ion to BN ratio was 0.2.

Comparative example 2

Using the thin film forming device shown in FIG. 17, a 2000Å thick BN film was formed on a substrate similar to that of Example 6 by vapor depositing a 99.9% pure h-BN from an electron beam evaporation source.

Comparative example 3

Using a magnetron sputtering device (not shown), a 2000Å thick BN film was formed by sputtering nitrogen ions to a sputtering target of 99.9% pure h-BN.

The respective samples of Examples 6 to 10 and Comparative examples 2 and 3 were subjected to infrared spectroscopy for analyses of these BN film properties together with thickness measurement using a 5gf Vickers micro-hardness gauge. The result is shown below in Table 3.

The Mn-Zn ferrite single crystal. plate used as the substrate had a Vickers hardness of 600.

Table 3

| | Absorption peaks of each sample by infrared spectroscopy | Vickers hardness |
|---|---|---|
| Example 6 | around 1380 cm$^{-1}$<br>around 780 cm$^{-1}$<br>around 1080 cm$^{-1}$ (small peak) | 1500 |
| Example 7 | around 1080 cm$^{-1}$<br>around 1380 cm$^{-1}$ (small peak)<br>around 780 cm$^{-1}$ (small peak) | 4500 |
| Example 8 | around 1380 cm$^{-1}$<br>around 780 cm$^{-1}$<br>around 1080 cm$^{-1}$ (small peak) | 1200 |
| Example 9 | around 1080 cm$^{-1}$<br>around 1380 cm$^{-1}$ (small peak)<br>around 780 cm$^{-1}$ (small peak) | 3000 |
| Example 10 | around 1380 cm$^{-1}$<br>around 780 cm$^{-1}$<br>around 1080 cm$^{-1}$ (small peak) | 3000 |
| Comparative Example 2 | around 1380 cm$^{-1}$<br>around 780 cm$^{-1}$ | 600 |
| Comparative Example 3 | around 1380 cm$^{-1}$<br>around 780 cm$^{-1}$ | 600 |

In the infrared spectroscopy for BN film quality, the absorption peaks observed at around wave numbers 1380 cm-1 and 780 cm-1 are attributable to the concentration of the h-BN structure, while the absorption peaks observed at around wave number 1080 cm$^{-1}$ are from the presence of the c-BN structure.

It is apparent from the above data not only that the samples of Examples 6 to 10 are harder than those of Comparative examples 2 and 3, but also that the BN films of the Examples 6 to 10 have both the c-BN structure that exhibits excellent wear resistance and the h-BN structure that exhibits satisfactory slidability.

An evaluation of film adhesion by lapping the above respective samples using a #6000 lapping tape indicated that BN film separation was observed only in the samples of Comparative examples 2 and 3, and not in those of Examples 6 to 10.

Thus, it can be said that the samples of Examples 6 to 10 are highly adhesive and hence have a satisfactory hardness.

While the thickness of the BN films was limited to 2000Å because of the use of the infrared spectrometer for structural analyses of the films in the above examples, the actual thickness of the film to be formed on the sliding surface of a magnetic head may be adjusted as necessary, in function of the eventual deterioration of magnetic properties such as sensitivity (S/N ratio) due to an increasing gap with respect to a magnetic recording medium. According to the invention, thicknesses in the order of several hundred Å may not change the structures and properties of the BN films.

In the event that the influence of the film quality on both the magnetic head and the magnetic recording medium that is slid along the magnetic head; e.g., too high a hardness of the BN film formed on the sliding surface of the magnetic head may damage the magnetic recording medium, the acceleration energy of ion injection and the B/N ratio may be adjusted to control the amount of generation of the c-BN and w-BN structures that are excellent in wear resistance and of the h-BN structure that is excellent in slidability in the BN film as appropriate.

According to the method of preparing a magnetic head of the invention, the BN film is formed either by vapor depositing the boron on the sliding surface of the magnetic head simultaneously or alternately with injecting the ions including the nitrogen ions or by vapor depositing the boron simultaneously or alternately with injecting the inert gas ions or hydrogen ions. Therefore, the c-BN and w-BN structures that are hard can positively be developed in the BN film by the injection of such ion species at ambient temperature. In addition, the growth of the h-BN structure can also be controlled by adjusting the ion injection energy, the B/N ratio, or the ion/BN ratio. As a result, the hard c-BN and h-BN structures are generated thereby to remarkably improve wear protection of the magnetic head and its life. The development of the h-BN structure in a proper amount makes the magnetic head satisfactorily slidable with its magnetic recording medium. Moreover, the development of the c-BN and w-BN structures in the BN film at ambient temperature by ion injection allows the film to be formed without having glass molten to fill the head grooves for regulating the track width, e.g., in video heads for video tape recorders, nor adversely affecting an adhesive for fixing the head in the sealed case. Such a process may be incorporated into the last process of magnetic head assembling, making its industrial applicability extremely high with the efficient processes.

The foregoing description of preferred embodiments of the invention has been presented for purposes of illustration and description. It is not intended to he exhaustive or to limit the invention to the precise form disclosed, and modifications and variations are possible in light of the above teachings or may be acquired from practice of the invention. The embodiments were chosen and described in order to explain the principles of the invention and its practical application to enable one skilled in the art to utilize the invention in various embodiments and with various modifications as are suited to the particular use contemplated. It is intended that the scope of the invention be defined by the claims appended hereto, and their equivalents.

**Claims**

1. A method of forming a thin film consisting of boron nitride comprising the step of injecting on a surface of a substrate nitrogen ions simultaneously or alternatively with vapor deposition of boron,
   **characterized in that**
   said method being conducted under the following conditions so that said thin film consists essentially of c-BN structure, where X (eV) is the acceleration energy of injection of said ions and Y is the particle ratio (B/N composition ratio) of boron atoms (B) and nitrogen atoms (N) to be contained in said thin film:
   when X ≤ 1000,

$$Y \geq 6.25 \times 10^{-4} \times (X\text{-}200) + 2$$
$$Y \leq 1.25 \times 10^{-3} \times (X\text{-}200) + 4;$$

   when 1000 < X ≤ 2000,

$$Y \geq 5.0 \times 10^{-4} \times (X\text{-}1000) + 2.5$$
$$Y \leq 5.0 \times 10^{-3} \times (X\text{-}1000) + 5;$$

   when 2000 < X ≤ 5000,

$$Y > 3.0$$
$$Y \leq 2/3 \times 10^{-3} \times (X\text{-}2000) + 10;$$

   when 5000 < x ≤ 10000,

$$Y > 4.0 \times 10^{-4} \times (X\text{-}5000) + 3$$
$$Y \leq 1.2 \times 10^{-3} \times (X\text{-}5000) + 12; \text{ and}$$

   when 10000 < X ≤ 40000,

$$Y \geq 1/3 \times 10^{-4} \times (X\text{-}10000) + 5$$
$$Y \leq 2/3 \times 10^{-3} \times (X\text{-}10000) + 18.$$

2. A method of forming a thin film containing boron nitride comprising the step of injecting on a surface of a substrate mixture ions of nitrogen ions and at least one kind of inert gas ions simultaneously or alternatively with vapor deposition of boron
   **characterized in that**
   the injection energy of said ions is limited to a range of from 500 eV to 2 keV, so that said thin film consists essentially of c-BN structure.

15

3. The method of forming a thin film containing boron nitride according to claim 2, wherein a mixed gas consisting of an inert gas and a nitrogen gas at a ratio (inert gas/nitrogen gas) of between 10 and 80% is supplied to an ion source.

4. A method of forming a thin film containing boron nitride according to claim 2, wherein a ratio of injection amount of said inert gas ions to said nitrogen ions is between 0.1 and 0.8.

5. The method of forming a thin film consisting of boron nitride according to claim 1, wherein said thin film consisting of boron nitride is vapor deposited on said sliding surface of said magnetic head.

6. A magnetic head comprising a sliding surface coated with a BN thin film consisting essentially of the c-BN structure in accordance with the method of claim 1.

7. A magnetic head comprising a sliding surface coated with a BN thin film consisting essentially of the c-BN structure in accordance with the method of claim 2.

**Patentansprüche**

1. Verfahren zum Bilden eines dünnen Films, welcher Bornitrid enthält, wobei auf eine Oberfläche eines Substrats Stickstoffionen gleichzeitig oder alternativ mit Dampfphasenabscheidung von Bor injiziert werden, **dadurch gekennzeichnet**, daß das Verfahren unter den folgenden Bedingungen ausgeführt wird, so daß der dünne Film im wesentlichen aus einer c-BN-Struktur besteht, wobei X (eV) die Beschleunigungsenergie der Injektion der Ionen und Y das Teilchenverhältnis (B/N Zusammensetzungsverhältnis) von Boratomen (B) und Stickstoffatomen (N), welche in dem dünnen Film enthalten sind, ist:
wenn $X \leq 1000$,

$$Y \geq 6{,}25 \times 10^{-4} \times (X\text{-}200) + 2$$
$$Y \leq 1{,}25 \times 10^{-3} \times (X\text{-}200) + 4;$$

wenn $1000 < X \leq 2000$,

$$Y \geq 5{,}0 \times 10^{-4} \times (X\text{-}1000) + 2{,}5$$
$$Y \leq 5{,}0 \times 10^{-3} \times (X\text{-}1000) + 5;$$

wenn $2000 < X \leq 5000$,

$$Y > 3{,}0$$
$$Y \leq 2/3 \times 10^{-3} \times (X\text{-}2000) + 10;$$

wenn $5000 < X \leq 10000$,

$$Y > 4{,}0 \times 10^{-4} \times (X\text{-}5000) + 3$$
$$Y \leq 1{,}2 \times 10^{-3} \times (X\text{-}5000) + 12; \text{ und}$$

wenn $10000 < X \leq 40000$,

$$Y \geq 1/3 \times 10^{-4} \times (X\text{-}10000) + 5$$
$$Y \leq 2/3 \times 10^{-3} \times (X\text{-}10000) + 18.$$

2. Verfahren zur Bildung eines dünnen Films, welcher Bornitrid enthält, wobei auf einer Oberfläche eines Substrats Mischionen aus Stickstoffionen und wenigstens einer Art von Inertgasionen gleichzeitig oder alternativ mit einer Dampfphasenabscheidung von Bor injiziert werden, **dadurch gekennzeichnet**, daß die Injektionsenergie der Ionen in einem Bereich von 500 eV bis 2 keV begrenzt ist, so daß der dünne Film im wesentlichen aus c-BN-Struktur besteht.

3. Verfahren zur Bildung eines dünnen Films, welcher Bornitrid enthält, nach Anspruch 2, wobei ein Mischgas, welches aus einem Inertgas und einem Stickstoffgas mit einem Verhältnis (Inertgas/Stickstoffgas) zwischen 10 und 80% besteht, einer Ionenquelle zugeführt wird.

4. Verfahren zur Bildung eines dünnen Films, welcher Bornitrid enthält, nach Anspruch 2, wobei ein Verhältnis der Injektionsmenge der Inertgasionen und der Stickstoffionen zwischen 0,1 und 0,8 ist.

5. Verfahren zur Bildung eines dünnen Films, welcher aus Bornitrid besteht, nach Anspruch 1, wobei der dünne Film, welcher aus Bornitrid besteht, als Dampf auf der Gleitoberfläche des Magnetkopfes abgelagert wird.

6. Magnetkopf mit einer Gleitoberfläche, welche mit einem BN dünnen Film beschichtet ist, der im wesentlichen aus der c-BN-Struktur gemäß dem Verfahren nach Anspruch 1 besteht.

7. Magnetkopf mit einer Gleitoberfläche, welche mit einem BN dünnen Film beschichtet ist, der im wesentlichen aus der c-BN-Struktur gemäß dem Verfahren nach Anspruch 2 besteht.

**Revendications**

1. Procédé de formation d'une pellicule mince consistant en nitrure de bore comprenant l'étape d'injection sur la surface d'un substrat d'ions d'azote simultanément ou en alternance avec la déposition en phase vapeur de bore,
caractérisé en ce que
ledit procédé est mis en oeuvre dans les conditions suivantes, où X (eV) est l'énergie d'accélération d'injection desdits ions et Y est le rapport des particules (rapport de composition B/N) des atomes de bore (B) et des atomes d'azote (N) que doit contenir ladite pellicule mince, de telle sorte que ladite pellicule mince consiste essentiellement en une structure c-BN :
lorsque $X \leq 1000$,

$$Y \geq 6,25 \times 10^{-4} \times (X-200) + 2 \text{ et}$$
$$Y \leq 1,25 \times 10^{-3} \times (X-200) + 4;$$

lorsque $1000 < X \leq 2000$,

$$Y \geq 5,0 \times 10^{-4} \times (X-1000) + 2,5 \text{ et}$$
$$Y \leq 5,0 \times 10^{-3} \times (X-1000) + 5;$$

lorsque $2000 < X \leq 5000$,

$$Y > 3,0 \text{ et}$$
$$Y \leq 2/3 \times 10^{-3} \times (X-2000) + 10;$$

lorsque $5000 < X \leq 10000$,

$$Y > 4,0 \times 10^{-4} \times (X-5000) + 3 \text{ et}$$
$$Y \leq 1,2 \times 10^{-3} \times (X-5000) + 12; \text{ et}$$

lorsque $10000 < X \leq 40000$,

$$Y \geq 1/3 \times 10^{-4} \times (X-10000) + 5 \text{ et}$$
$$Y \leq 2/3 \times 10^{-3} \times (X-10000) + 18.$$

2. Procédé de formation d'une pellicule mince contenant du nitrure de bore comprenant l'étape d'injection sur la surface d'un substrat d'un mélange d'ions d'azote et d'au moins un type d'ions de gaz inerte simultanément ou en alternance avec la déposition en phase vapeur de bore,
caractérisé en ce que
l'énergie d'injection desdits ions est limitée à l'intervalle de 500 eV à 2 keV, de telle sorte que ladite pellicule mince consiste essentiellement en la structure c-BN.

3. Procédé de formation d'une pellicule mince contenant du nitrure de bore selon la revendication 2, dans lequel on amène à une source d'ions un mélange gazeux consistant en un gaz inerte et en azote dans un rapport (gaz inerte/azote) compris entre 10 et 80 %.

4. Procédé de formation d'une pellicule mince contenant du nitrure de bore selon la revendication 2, dans lequel le rapport d'injection desdits ions de gaz inerte auxdits ions d'azote est compris entre 0,1 et 0,8.

5. Procédé de formation d'une pellicule mince consistant en nitrure de bore selon la revendication 1, dans lequel ladite pellicule mince consistant en nitrure de bore est déposée en phase vapeur sur ladite surface de glissement de ladite tête magnétique.

6. Tête magnétique comprenant une surface de glissement revêtue d'une pellicule mince de BN consistant essentiellement en la structure c-BN préparée par le procédé selon la revendication 1.

7. Tête magnétique comprenant une surface de glissement revêtue d'une pellicule mince de BN consistant essentiellement en la structure c-BN préparée par le procédé selon la revendication 2.

FIG. 1

FIG. 2

## FIG. 3

## FIG. 4

## FIG. 5

20

FIG. 6

FIG. 7

FIG. 8

FIG. 9

# FIG. 10

# FIG. 11

# FIG. 12

# FIG. 13

## FIG. 14

1380⁻¹cm    780⁻¹cm

## FIG. 15

1380⁻¹cm    780⁻¹cm

FIG. 16

FIG. 17

FIG. 18